# EUROPÄISCHE PATENTANMELDUNG

(11) **EP 3 683 588 A1**
(43) Veröffentlichungstag der Anmeldung: **22.07.2020**
(21) Anmeldenummer: 19152197.0
(22) Anmeldetag: 17.01.2019
(51) Int. Cl.: G01R 31/00

(54) **VERFAHREN UND PRÜFVORRICHTUNG ZUM PRÜFEN EINES ELEKTROBAUTEILS**

(71) Anmelder: Lisa Dräxlmaier GmbH, 84137 Vilsbiburg (DE)
(72) Erfinder: Els, Thomas, 85646 Anzing (DE); Braun, Udo, 84137 Vilsbiburg (DE)

(57) **Zusammenfassung**

Die vorliegende Erfindung bezieht sich auf ein Verfahren zum Prüfen eines Elektrobauteils (102), das dadurch gekennzeichnet ist, dass das Elektrobauteil (102) elektrisch kontaktiert wird, unter Verwendung einer auf eine Prüftemperatur (116) temperierten, dielektrischen Prüfflüssigkeit (110) auf die Prüftemperatur (116) temperiert wird, zumindest ein elektrisches Signal (128) von dem in der Prüfflüssigkeit (110) angeordneten Elektrobauteil (102) empfangen wird, das Elektrobauteil (102) nach dem Prüfen aus der Prüfflüssigkeit (110) entfernt, getrocknet und elektrisch getrennt wird.

## Beschreibung

### Technisches Gebiet

Die vorliegende Erfindung betrifft ein Verfahren und eine Prüfvorrichtung zum Prüfen eines Elektrobauteils.

### Stand der Technik

Bauteile können nach der Produktion und vor der Auslieferung beziehungsweise bestimmungsgemäßen Verwendung in einer Klimakammer gelagert werden, um sie z.B. auch durch eine Alterung bei definierten Umweltbedingungen in einen stabilen Auslieferungszustand zu versetzen. In der Klimakammer wird Luft erwärmt oder abgekühlt. Durch Umwälzung der Luft wird eine Temperatur der Bauteile an eine Temperatur der Luft angeglichen. Bei feuchtigkeitsempfindlichen Elektrobauteilen kann die Luft in der Klimakammer entfeuchtet werden, um bei Temperaturänderungen, insbesondere beim Erwärmen der Luft Kondensation auf den noch kälteren Elektrobauteilen und damit Korrosionsprobleme zu verhindern. Eine Herausforderung dabei sind die langen Wartezeiten, bis die Temperatur der Bauteile an die Temperatur der Luft sich angeglichen hat. Kontakt mit Flüssigkeit wird generell vermieden, da Kriechströme resultieren können, die insbesondere eine elektrische Funktionstüchtigkeit der Bauteile einschränken können.

### Beschreibung der Erfindung

Eine Aufgabe der Erfindung ist es daher, unter Einsatz konstruktiv möglichst einfacher Mittel ein Verfahren und eine Prüfvorrichtung zum Prüfen eines Elektrobauteils bereitzustellen.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben. Insbesondere können die unabhängigen Ansprüche einer Anspruchskategorie auch analog zu den abhängigen Ansprüchen einer anderen Anspruchskategorie weitergebildet sein.

Es wird ein Verfahren zum Prüfen eines Elektrobauteils vorgestellt, welches dadurch gekennzeichnet ist, dass das Elektrobauteil elektrisch kontaktiert wird, unter Verwendung einer auf eine Prüftemperatur temperierten, dielektrischen Prüfflüssigkeit auf die Prüftemperatur temperiert wird, zumindest ein elektrisches Signal von dem in der Prüfflüssigkeit angeordneten Elektrobauteil empfangen wird, das Elektrobauteil nach dem Prüfen aus der Prüfflüssigkeit entfernt, getrocknet und elektrisch getrennt wird.

Die angegebenen Verfahrensschritte werden dabei vorzugsweise in der angegebenen Reihenfolge ausgeführt. Die angegebenen Verfahrensschritte können sich auch teilweise zeitlich überlappen. So kann beispielsweise bereits mit dem Temperieren der dielektrischen Prüfflüssigkeit auf die Prüftemperatur begonnen werden, während das Elektrobauteil elektrisch kontaktiert wird.

Ein Elektrobauteil kann eine Baugruppe aus unterschiedlichen Komponenten sein. Beispielsweise kann das Elektrobauteil Komponenten wie Halbleiterkomponenten, elektromechanische Komponenten, elektrische Leiter und Elektronikkomponenten umfassen. Die Komponenten können auf zumindest einer Leiterplatte angeordnet sein. Das Elektrobauteil kann aber auch ein einzelnes Bauelement, wie eine Leuchtdiode sein. Das Elektrobauteil weist zumindest einen elektrisch kontaktierbaren Anschluss auf, der elektrisch kontaktiert wird. Der elektrische Kontakt kann durch Kontaktflächen in einer mechanischen Aufnahme für das Elektrobauteil hergestellt werden. Beispielsweise können Steckkontakte und/oder Kontaktpins des Elektrobauteils in entsprechenden Aufnahmen kontaktiert werden.

Das Elektrobauteil kann an eine Versorgungsspannung angeschlossen werden. Für die Signalübertragung kann der Anschluss verwendet werden. Ebenso kann ein dezidierter Signalanschluss verwendet werden. Das Signal kann ein analoges Stromsignal oder ein analoges Spannungssignal sein. Ebenso kann das Signal ein digitales Signal sein. Das Signal kann von dem Elektrobauteil ansprechend auf ein Bereitstellungssignal bereitgestellt werden. Ebenso kann das Signal ohne Aufforderung dauerhaft anliegen. Das Signal kann mit einer elektrischen Spannung typischerweise im Bereich weniger Volt wiedergegeben sein.

Eine dielektrische Prüfflüssigkeit ist elektrisch nicht leitend und kann somit elektrisch isolierend sein. Als Dielektrikum wird jede elektrisch schwach- oder nichtleitende, nichtmetallische Substanz bezeichnet, deren Ladungsträger im Allgemeinen praktisch nicht frei beweglich sind. Ein Dielektrikum kann eine Flüssigkeit sein. Dabei sollte die dielektrische Prüfflüssigkeit eine Leitfähigkeit aufweisen, die zumindest klein genug ist, dass es aufgrund der das Signal wiedergebenden elektrischen Spannung zu keinem das Elektrobauteil schädigenden elektrischen Stromfluss kommt. Ferner kann die dielektrische Prüfflüssigkeit inert beziehungsweise reaktionsträge sein. Das Elektrobauteil kann vor oder nach dem Kontaktieren in der dielektrischen Prüfflüssigkeit angeordnet werden. Beispielsweise kann das Elektrobauteil in die Prüfflüssigkeit eingetaucht werden. Die Prüfflüssigkeit kann aber auch in einen Behälter eingeleitet werden, in dem das Elektrobauteil zuvor angeordnet worden ist. Ebenso kann das Elektrobauteil in einem Strahl der Prüfflüssigkeit angeordnet werden.

Die Prüfflüssigkeit kann durch eine Temperiereinrichtung auf die vordefinierte Prüftemperatur temperiert werden. Die Prüftemperatur kann in einem großen Temperaturbereich liegen. Das Elektrobauteil kann durch einen direkten fluidischen und wärmeleitenden Kontakt zu der Prüfflüssigkeit temperiert werden. Die Prüfflüssigkeit kann Verunreinigungen des Elektrobauteils lösen und entfernen. Nach dem Trocknen kann die Prüfflüssigkeit einen Schutzfilm auf dem Elektrobauteil hinterlassen.

Als Signal kann zumindest ein Temperaturwert von einem Temperatursensor des Elektrobauteils empfangen werden und unter Verwendung eines die Prüftemperatur angebenden Werts und des Temperaturwerts ein Korrekturfaktor ermittelt werden. Mit anderen Worten kann das Signal einen Temperaturwert repräsentieren. Der Korrekturfaktor kann je nach Elektrobauteil auf dem Elektrobauteil gespeichert werden. Der Korrekturfaktor kann zum Justieren und Kalibrieren des Temperatursensors verwendet werden. Der Korrekturfaktor kann an das Elektrobauteil gesendet werden, während es in der Prüfflüssigkeit angeordnet ist. Ebenso kann der Korrekturfaktor nach dem Prüfen an das Elektrobauteil gesendet werden.

Eine Verweildauer in der temperierten Prüfflüssigkeit kann abgewartet werden. Der für den Korrekturfaktor verwendete Temperaturwert kann nach der Verweildauer empfangen werden. Der für den Korrekturfaktor verwendete Temperaturwert kann ebenso empfangen werden, wenn ein Gradient des Temperaturwerts kleiner als eine Toleranz ist, d.h. unterhalb oder oberhalb eines vordefinierten Schwellwerts für den Gradienten des Temperaturwerts oder in einem Toleranzbereich für den Gradienten des Temperaturwerts liegt. Durch die Verweildauer kann sich eine Temperatur des Elektrobauteils an die vordefinierte Prüftemperatur der Prüfflüssigkeit anpassen.

Zumindest ein elektrisches Steuersignal kann an das in der Prüfflüssigkeit angeordnete Elektrobauteil gesendet werden. Unter Verwendung des Steuersignals kann eine elektrische Funktion des Elektrobauteils angesteuert werden. Unter Verwendung des empfangenen Signals kann eine Ausführung der Funktion überwacht werden. So kann überprüft werden, ob das Elektrobauteil bestimmungsgemäß funktioniert.

Das Elektrobauteil kann auf eine Abfolge von unterschiedlichen (vordefinierten) Prüftemperaturen temperiert werden. Bei jeder Prüftemperatur kann zumindest ein Signal empfangen beziehungsweise ausgelesen werden. Mehrere Prüftemperaturen nacheinander ergeben ein Temperaturprofil. Beispielsweise kann das Elektrobauteil zuerst unter eine Ausgangstemperatur abgekühlt werden. Dann kann das Elektrobauteil über die Ausgangstemperatur erwärmt werden. Durch unterschiedliche Prüftemperaturen können chemische und/oder physikalische Prozesse simuliert werden. Das Temperaturprofil kann Temperaturrampen aufweisen. Bei einer Temperaturrampe steigt oder fällt die Prüftemperatur stetig.

Während der Abfolge von Prüftemperaturen kann eine Mehrzahl von Temperaturwerten ausgelesen werden. Unter Verwendung von Werten (Temperaturwerten), welche die jeweilige Prüftemperatur angeben, kann je ein Korrekturfaktor ermittelt werden. Die Korrekturfaktoren können als Korrekturtabelle auf das Elektrobauteil aufgespielt werden. Die Korrekturtabelle kann beispielsweise am Ende der Prüfung aufgespielt werden. Die einzelnen Korrekturfaktoren können auch nacheinander aufgespielt werden. So kann das Elektrobauteil kalibriert werden.

Die Prüfflüssigkeit kann auf die Abfolge der unterschiedlichen Prüftemperaturen temperiert werden. Das Elektrobauteil kann in der Prüfflüssigkeit verbleiben. Alternativ können unterschiedliche Behälter unterschiedlich temperierte Prüfflüssigkeit enthalten. Dann kann das Elektrobauteil von Behälter zu Behälter bewegt werden.

Das Elektrobauteil kann in einer Prüfvorrichtung angeordnet und von der Prüfvorrichtung elektrisch kontaktiert werden. Das Elektrobauteil kann unter Verwendung der Prüfvorrichtung in der Prüfflüssigkeit angeordnet werden. Die Signale können unter Verwendung der Prüfvorrichtung empfangen werden. Das Elektrobauteil kann nach dem Prüfen unter Verwendung der Prüfvorrichtung aus der Prüfvorrichtung entnommen werden. Nach dem Prüfen kann das Elektrobauteil elektrisch von der Prüfvorrichtung getrennt werden. Die Prüfvorrichtung kann automatisch bestückt werden. Das Elektrobauteil kann automatisch aus der Prüfvorrichtung entnommen werden. In der Prüfvorrichtung können mehrere Elektrobauteile angeordnet werden. Die angegebenen Schritte können vorzugsweise in der angegebenen Reihenfolge ausgeführt werden.

Das Elektrobauteil kann zum Temperieren von der Prüfflüssigkeit umströmt werden. Durch eine Relativbewegung zwischen dem Elektrobauteil und der Prüfflüssigkeit kann ein Wärmeübergang verbessert werden. Die Prüfflüssigkeit kann auch turbulent an dem Elektrobauteil vorbeiströmen. Durch die turbulente Strömung kann der Wärmeübergang optimiert werden. Weiterhin kann dadurch eine homogenere Temperaturverteilung erzielt werden.

Das Elektrobauteil kann für eine Alterungszeitdauer in der Prüfflüssigkeit angeordnet bleiben. Das Elektrobauteil kann gezielt gealtert werden, um das Elektrobauteil beispielsweise in eine stabile Phase zu bringen. Durch das Temperieren in der Prüfflüssigkeit kann die Alterung beschleunigt werden. So ergeben sich kurze Alterungszeitdauern. Während der Alterungszeitdauer kann ein Temperaturprofil abgefahren werden.

Der hier vorgestellte Ansatz schafft ferner eine Prüfvorrichtung, die dazu ausgebildet ist, um die Schritte einer Variante des hier vorgestellten Verfahrens in entsprechenden Einrichtungen durchzuführen, anzusteuern bzw. umzusetzen.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

### Kurze Figurenbeschreibung

Nachfolgend wird ein vorteilhaftes Ausführungsbeispiel der Erfindung unter Bezugnahme auf die begleitende Figur erläutert. Es zeigt:

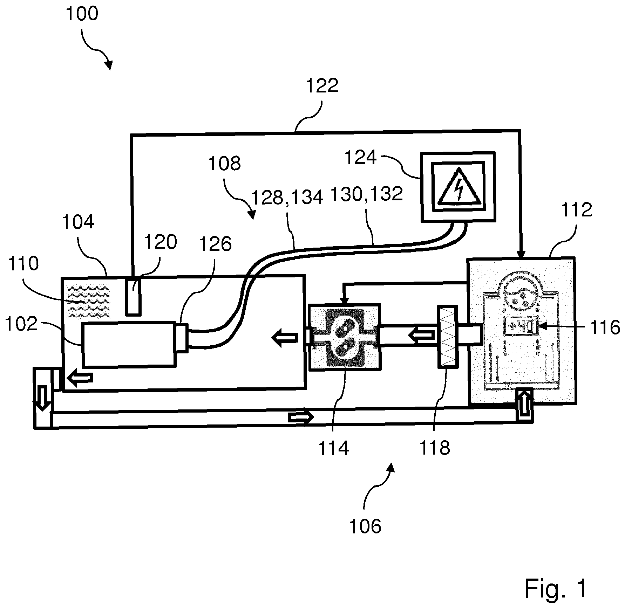

Fig. 1 eine Darstellung einer Prüfvorrichtung gemäß einem Ausführungsbeispiel.

Die Figur ist lediglich eine schematische Darstellung und dient nur der Erläuterung der Erfindung. Gleiche oder gleichwirkende Elemente sind durchgängig mit den gleichen Bezugszeichen versehen.

### Detaillierte Beschreibung

Fig. 1 zeigt eine Darstellung einer Prüfvorrichtung 100 gemäß einem Ausführungsbeispiel. Die Prüfvorrichtung 100 ist dazu ausgebildet, zumindest ein Elektrobauteil 102 zu temperieren und dabei elektrisch zu prüfen. Die Prüfvorrichtung 100 weist einen Behälter 104 zum Temperieren und Prüfen des Elektrobauteils 102 auf. An den Behälter 104 sind ein Flüssigkeitssystem 106 und ein Elektrosystem 108 angeschlossen. Das Flüssigkeitssystem 106 ist dazu ausgebildet, eine temperierte Prüfflüssigkeit 110 bereitzustellen. Die Prüfflüssigkeit 110 ist dielektrisch, also elektrisch isolierend. Zusätzlich ist die Prüfflüssigkeit inert. Das Elektrobauteil 102 kann also problemlos in der Prüfflüssigkeit 110 angeordnet werden. Das Elektrosystem 108 ist dazu ausgebildet, das Elektrobauteil 102 elektrisch zu prüfen, während es in der temperierten Prüfflüssigkeit 110 angeordnet ist. Durch den direkten wärmeleitenden Kontakt zur Prüfflüssigkeit 110 nimmt das Elektrobauteil 102 sehr schnell eine Temperatur der Prüfflüssigkeit 110 an. Die Temperatur der Prüfflüssigkeit kann innerhalb eines großen Temperaturbereichs eingestellt werden.

Zum Temperieren weist das Flüssigkeitssystem 106 eine Temperiereinrichtung 112 und eine Umwälzeinrichtung 114 auf.

Die Temperiereinrichtung 112 ist dazu ausgebildet, die Prüfflüssigkeit 110 auf eine genaue Prüftemperatur 116 zu temperieren. Dazu kann die Temperiereinrichtung 112 beispielsweise zumindest einen von der Prüfflüssigkeit 110 durchströmten Wärmetauscher aufweisen. Der Wärmetauscher kann beispielsweise mit einer Kältemaschine und/oder einem Peltierelement gekoppelt sein. Im Wärmetauscher kann die Prüfflüssigkeit 110 abgekühlt oder erwärmt werden. Zum Erwärmen der Prüfflüssigkeit 110 kann beispielsweise die Kältemaschine als Wärmepumpe betrieben werden. Alternativ oder ergänzend kann die Temperiereinrichtung 112 zumindest ein von der Prüfflüssigkeit 110 angeströmtes Heizelement aufweisen, das beispielsweise elektrisch beheizbar ist.

Die Umwälzeinrichtung 114 ist dazu ausgebildet, die Prüfflüssigkeit 110 in einem Flüssigkeitskreislauf durch den Behälter 104 und die Temperiereinrichtung 112 zu pumpen. Da die Prüfflüssigkeit 110 den Behälter 104 durchströmt, wird die Prüftemperatur 116 bei einer Temperaturänderung im ganzen Behälter 104 sehr schnell gleichmäßig verteilt. Die Umwälzeinrichtung 114 ist hier beispielsweise eine Drehkolbenpumpe. Zwischen der Temperiereinrichtung 112 und der Umwälzeinrichtung 114 ist hier ein Filter 118 zum Entfernen von Fremdkörpern und Verschmutzungen aus der Prüfflüssigkeit 110 angeordnet.

Zum Messen der Prüftemperatur 116 weist die Temperiereinrichtung 112 zumindest einen Temperaturfühler 120 im Behälter 104 auf. Der Temperaturfühler 120 stellt einen Ist-Wert 122 der Prüftemperatur 116 bereit. Die Temperiereinrichtung 112 kühlt oder heizt so lange, bis der Ist-Wert 122 innerhalb einer Toleranz (innerhalb eines Toleranzbereichs) um die einzustellende Prüftemperatur 116 liegt.

Das Elektrosystem 108 weist eine Prüfelektronik 124 und eine in dem Behälter 104 anordenbare elektrische Schnittstelle 126 zu dem Elektrobauteil 102 auf. Die Prüfelektronik 124 ist außerhalb des Behälters 104 angeordnet und über elektrische Leiter mit der Schnittstelle 126 verbunden. Über die Schnittstelle 126 kann die Prüfelektronik 124 elektrische Signale 128 von dem Elektrobauteil 102 einlesen, während es in der Prüfflüssigkeit 110 angeordnet ist.

Beispielsweise kann ein Temperaturwert 130 von einem Temperatursensor des Elektrobauteils 102 eingelesen werden. In Der Prüfelektronik 124 kann unter Verwendung der Prüftemperatur 116 und dem Temperaturwert 130 ein Korrekturfaktor 132 berechnet werden. Der Korrekturfaktor 132 kann auf das Elektrobauteil 102 aufgespielt werden, um den Temperatursensor zu justieren.

In einem Ausführungsbeispiel weist die Prüfelektronik 126 eine Spannungsversorgung für das Elektrobauteil 102 auf. So können elektrische Prozesse auf dem Elektrobauteil 102 über Steuersignale 134 angesteuert und ausgeführt werden, wenn es in der Prüfflüssigkeit 110 angeordnet ist.

In einem Ausführungsbeispiel ist die Schnittstelle 126 fest im Behälter 104 angeordnet. Um Das Elektrobauteil 102 mit der Schnittstelle 126 zu verbinden, kann die Prüfflüssigkeit 110 aus dem Behälter 104 in einen hier nicht dargestellten Vorratsbehälter gepumpt werden. Die Schnittstelle 126 kann eine Mehrzahl von Steckplätzen für gleichartige Elektrobauteile 102 aufweisen. So kann der geleerte Behälter 104 einfach mit den Elektrobauteilen 102 bestückt werden und anschließend wieder mit der Prüfflüssigkeit 110 gefüllt werden, bis die Elektrobauteile 102 beziehungsweise zu prüfenden Bereiche der Elektrobauteile 102 vollständig von der Prüfflüssigkeit 110 bedeckt sind.

In einem Ausführungsbeispiel ist in dem Behälter 104 ein hier nicht dargestellter Halter für das zumindest eine Elektrobauteil 102 angeordnet. Das Elektrobauteil 102 kann außerhalb des Behälters 104 mit der Schnittstelle 126 verbunden werden und dann mit der Schnittstelle 126 in dem Halter angeordnet werden. Durch den Halter können viele Elektrobauteile 102 nebeneinander im Behälter angeordnet werden. Nicht zu prüfende Bereiche der Elektrobauteile 102 können aus dem Behälter 104 herausragen.

In einem Ausführungsbeispiel wird die Prüfflüssigkeit 110 nacheinander auf unterschiedliche Prüftemperaturen 116 temperiert. Wenn der Ist-Wert 122 der Prüftemperatur 116 entspricht, wird die Prüftemperatur 116 so lange stabil gehalten. Bis das Elektrobauteil 102 die Prüftemperatur 116 angenommen hat. Dann kann der resultierende Temperaturwert 130 ausgelesen werden und zu der gerade eingeregelten Prüftemperatur 116 ein Korrekturfaktor 132 berechnet werden. Aus mehreren Korrekturfaktoren 132 kann eine Korrekturtabelle erstellt werden und auf das Elektrobauteil 102 aufgespielt werden.

Mit anderen Worten wird ein thermisches Prüfungsverfahren für Elektrik-, LED- sowie Elektronikbauteile auf Dielektrikum Basis vorgestellt.

Bei der Temperaturkalibrierung und -justierung sowie dem Alterungsverfahren von Elektrik-, LED- sowie Elektronikbauteilen sind in der Großserie im Klimaschrank längere Wartezeiten für die homogene Durchtemperierung der Bauteile/Prüflinge notwendig. Diese belaufen sich je nach Größe von Bauteil und Prüfkammervolumen auf bis zu mehrere Stunden. Dadurch entstehen lange Prozesszeiten. Darüber hinaus ist das Temperieren der Bauteile/Prüflinge im Klimaschrank mit relativ hohen Invest- und Betriebskosten anzusetzen. Zusätzlich unterliegt dieser Prozess grundlegenden physikalischen Nachteilen, wie Wärme- und Kältenestern im Klimaschrank und der schlechten Temperaturleitfähigkeit und Temperaturübergangskoeffizienten von Luft.

Bei dem hier vorgestellten Ansatz findet die Temperaturkalibrierung und -justierung und/oder das Alterungsverfahren von Elektrik-, LED- und Elektronikbauteilen in einer als spezielle Flüssigkeit (Dielektrikum) bezeichneten Prüfflüssigkeit statt. Flüssigkeiten haben neben einer besseren Wärmeleitfähigkeit als Luft vor allem den Vorteil, einen für den Prozess günstigeren Wärmeübergangskoeffizienten als Luft zu besitzen. Dadurch werden die Bauteile/Prüflinge in der speziellen Flüssigkeit beziehungsweise Prüfflüssigkeit wesentlich schneller temperiert als in Luft. Beispielsweise kann die Temperierung um den Faktor sechs schneller erfolgen.

Neben den thermischen Eigenschaften ist die spezielle Flüssigkeit beziehungsweise Prüfflüssigkeit elektrisch nicht leitend, inert, nicht gesundheits- oder umweltschädlich (kein Gefahrgut), nicht brennbar, nicht entflammbar, weist eine geringe Toxizität, ein niedriges Treibhauspotenzial (GWP) und ein Ozonabbaupotenzial von Null (ODP) auf.

Die Bauteile/Prüflinge werden direkt die spezielle Flüssigkeit eingetaucht, temperiert, kalibriert/justiert bzw. gealtert. Falls notwendig können die Bauteile/Prüflinge während des Prozesses mit elektrischer Spannung versorgt werden bzw. Bussysteme angeschlossen werden.

Bisher wird bei der bekannten Temperaturkalibrierung bzw. Justierung sowie bei Alterungsverfahren von Elektrik-, LED- und Elektronikbauteilen in der Großserie ein luftgekühlter Prüfraum (z.B. ein Klimaschrank) verwendet. Falls notwendig werden die Bauteile/Prüflinge zuvor auf einem Warenträger (WT) mechanisch fixiert, elektrisch kontaktiert und in den Prüfraum geschoben. Nach Prozessstart wird eine produktspezifische Temperaturkurve mit den notwendigen Wartezeiten zur Durchtemperierung abgefahren und die Bauteile somit kalibriert/justiert.

Durch das hier beschriebene Kalibrier-, Justier- beziehungsweise Alterungsverfahren von Elektrik-, LED- und Elektronikbauteilen in der speziellen Flüssigkeit (Dielektrikum) können Prozesse bei Sensoren sowie der LED-Technik wesentlich effizienter, zeit- und kostensparender eingesetzt werden.

Der hier vorgestellte Ansatz beschreibt ein High-Tech-Verfahren zum Wärmemanagement in der Elektrik-, Elektronik-, LED-Technik und optischen Industrie, um gestiegenen Ansprüchen an Produkte gerecht zu werden. Insbesondere können besonders vorteilhaft Kalibrier-Justier- sowie Alterungsverfahren von Elektrik-, LED- und Elektronikbauteilen mit dem hier vorgestellten Verfahren durchgeführt werden.

Durch eine Minimierung der Durchlaufzeiten sowie eine effizientere Flexibilität werden Herstellkosten gesenkt. Ebenso werden Invest-, Betriebs- und Platzkosten reduziert. Die Produktqualität kann durch eine homogenere Temperaturverteilung am Produkt gesteigert werden.

Für das Betreiben des Prozesses mit der speziellen Flüssigkeit (Dielektrikum) können modulare Grundeinheiten verwendet werden. Für die Industrialisierung dieses Prozesses können Sensorik, Temperaturregelinstrumente sowie ein Transport- und Trocknungssystem verwendet werden. Anlagenbestandteile können ein Flüssigkeitsspeicher für das Dielektrikum, eine Temperatur-Regelung, -Steuerung, -Sensorik, ein Temperaturmischer mit Überwachung, eine Trockeneinheit mit Gebläse und Dielektrikum-Rückführung, eine Transport Einheit mit Platinen-Stromversorgung und mechanischer Aufnahme der Platinen, eine Systemsteuerung, eine Prüfsoftware mit integrierter Abgleich-Berechnung sowie eine Datenbank zur Verwaltung aller Messdaten sein.

Die speziellen Flüssigkeiten (Dielektrika) sind chemischen Medien mit niedrigem Treibhauspotenzial, die sicher in der Anwendung und zukunftsgerecht sind. Diese speziellen Flüssigkeiten (Dielektrika) zeichnen sich in der Wärmetransportanwendung durch sehr gute dielektrische Eigenschaften, viele verschiedene mögliche Siedepunkte und gute Werkstoffverträglichkeit aus.

Die Flüssigkeiten erfordern einen geringen Wartungsaufwand und gewährleisten eine zuverlässige Performance. Sie verfügen über einen hohen elektrischen Isolationswiderstand und verursachen daher im Falle einer Undichtigkeit oder eines anderen Fehlers keine Schäden an elektronischen Geräten oder integrierten Schaltungen.

Da es sich bei den vorhergehend detailliert beschriebenen Vorrichtungen und Verfahren um Ausführungsbeispiele handelt, können sie in üblicher Weise vom Fachmann in einem weiten Umfang modifiziert werden, ohne den Bereich der Erfindung zu verlassen. Insbesondere sind die mechanischen Anordnungen und die Größenverhältnisse der einzelnen Elemente zueinander lediglich beispielhaft gewählt.

### BEZUGSZEICHENLISTE

- 100: Prüfvorrichtung
- 102: Elektrobauteil
- 104: Behälter
- 106: Flüssigkeitssystem
- 108: Elektrosystem
- 110: Prüfflüssigkeit
- 112: Temperiereinrichtung
- 114: Umwälzeinrichtung
- 116: Prüftemperatur
- 118: Filter
- 120: Temperaturfühler
- 122: Ist-Wert
- 124: Prüfelektronik
- 126: Schnittstelle
- 128: Signal
- 130: Temperaturwert
- 132: Korrekturfaktor
- 134: Steuersignal

## Patentansprüche

1. Verfahren zum Prüfen eines Elektrobauteils (102), **dadurch gekennzeichnet, dass** das Elektrobauteil (102) elektrisch kontaktiert wird, unter Verwendung einer auf eine Prüftemperatur (116) temperierten, dielektrischen Prüfflüssigkeit (110) auf die Prüftemperatur (116) temperiert wird, zumindest ein elektrisches Signal (128) von dem in der Prüfflüssigkeit (110) angeordneten Elektrobauteil (102) empfangen wird, das Elektrobauteil (102) nach dem Prüfen aus der Prüfflüssigkeit (110) entfernt, getrocknet und elektrisch getrennt wird.

2. Verfahren gemäß Anspruch 1, bei dem als Signal (128) zumindest ein Temperaturwert (130) von einem Temperatursensor des Elektrobauteils (102) empfangen wird und unter Verwendung eines die Prüftemperatur (116) repräsentierenden Werts und des Temperaturwerts (130) ein Korrekturfaktor (132) ermittelt wird.

3. Verfahren gemäß Anspruch 2, bei dem eine Verweildauer in der temperierten Prüfflüssigkeit (110) abgewartet wird, und der für den Korrekturfaktor (132) verwendete Temperaturwert (130) nach der Verweildauer empfangen wird.

4. Verfahren gemäß einem der vorhergehenden Ansprüche, bei dem zumindest ein elektrisches Steuersignal (134) an das in der Prüfflüssigkeit (110) angeordnete Elektrobauteil (102) gesendet wird, wobei unter Verwendung des Steuersignals (134) eine elektrische Funktion des Elektrobauteils (102) angesteuert wird und unter Verwendung des empfangenen Signals (128) eine Ausführung der Funktion überwacht wird.

5. Verfahren gemäß einem der vorhergehenden Ansprüche, bei dem das Elektrobauteil (102) auf eine Abfolge von unterschiedlichen Prüftemperaturen (116) temperiert wird.

6. Verfahren gemäß Anspruch 5, bei dem während der Abfolge von Prüftemperaturen (116) eine Mehrzahl von Temperaturwerten (130) ausgelesen wird und unter Verwendung eines die jeweilige Prüftemperatur (116) angebenden Werts je ein Korrekturfaktor (132) ermittelt wird, wobei die Korrekturfaktoren (132) als Korrekturtabelle auf das Elektrobauteil (102) aufgespielt werden.

7. Verfahren gemäß einem Ansprüche 5 bis 6, bei dem die Prüfflüssigkeit (110) auf die Abfolge der unterschiedlichen Prüftemperaturen (116) temperiert wird.

8. Verfahren gemäß einem der vorhergehenden Ansprüche, bei dem das Elektrobauteil (102) in einer Prüfvorrichtung (100) angeordnet und von der Prüfvorrichtung (100) elektrisch kontaktiert wird, unter Verwendung der Prüfvorrichtung (100) in der Prüfflüssigkeit (110) angeordnet wird, unter Verwendung der Prüfvorrichtung (100) die Signale (128) empfangen werden und nach dem Prüfen aus der Prüfvorrichtung (100) entnommen und elektrisch von der Prüfvorrichtung (100) getrennt wird.

9. Verfahren gemäß einem der vorhergehenden Ansprüche, bei dem das Elektrobauteil (102) zum Temperieren von der Prüfflüssigkeit (110) umströmt wird.

10. Verfahren gemäß einem der vorhergehenden Ansprüche, bei dem das Elektrobauteil (102) für eine Alterungszeitdauer in der Prüfflüssigkeit (110) angeordnet bleibt.

11. Prüfvorrichtung (100) zum Prüfen eines Elektrobauteils (102), wobei die Prüfvorrichtung (100) dazu ausgebildet ist, das Verfahren gemäß einem der vorhergehenden Ansprüche in entsprechenden Einrichtungen auszuführen, umzusetzen und/oder anzusteuern.

12. Computerprogrammprodukt, das dazu eingerichtet ist, das Verfahren gemäß einem der Ansprüche 1 bis 10 auszuführen, umzusetzen und/oder anzusteuern.

13. Maschinenlesbares Speichermedium, auf dem das Computerprogrammprodukt gemäß Anspruch 12 gespeichert ist.
